# EUROPÄISCHE PATENTSCHRIFT

(11) **EP 0 756 442 B1**
(45) Veröffentlichungstag und Bekanntmachung des Hinweises auf die Patenterteilung: **01.12.1999**
(21) Anmeldenummer: 96202054.1
(22) Anmeldetag: 19.07.1996
(51) Int. Cl.: H05K 3/34, B23K 1/008, B23K 1/012

(54) **Verfahren zum Löten von Bauelementen auf einer Trägerfolie**
Method of soldening components to a carrier foil
Procédé de soudage de composants sur une feuille de support

(30) Priorität: 27.07.1995 DE 19527398
(43) Veröffentlichungstag der Anmeldung: 29.01.1997
(73) Patentinhaber: Philips Patentverwaltung GmbH, 22335 Hamburg (DE); Koninklijke Philips Electronics N.V., 5621 BA Eindhoven (NL)
(72) Erfinder: Backer, Heiko, c/o Philips Patentverwaltung GmbH,, 22335 Hamburg (DE); Wendt, Reinhard c/o Philips Patentverwaltung GmbH, 22335 Hamburg (DE)
(74) Vertreter: Hartmann, Heinrich, Dipl.-Ing.

(56) Entgegenhaltungen:
- EP-A- 0 307 319
- FR-A- 2 573 950
- US-A- 4 295 596

## Beschreibung

Die Erfindung betrifft ein Verfahren zum Löten von Bauelementen auf einer Trägerfolie, bei dem heißes Gas auf die Unterseite der Trägerfolie geleitet wird. Die Erfindung betrifft außerdem eine Anordnung zur Durchführung dieses Verfahrens.

Eine der Hauptanforderungen an die Schaltungstechnik besteht darin, immer mehr Funktionen auf immer weniger Platz unterzubringen. Dazu werden verschiedene Techniken benutzt. In der SMD-Technik (SMD=Surface mounted devices) werden sehr klein ausgeführte diskrete Bauelemente auf die Oberfläche einer Platine oder Trägerfolie gelötet. In einer sogenannten Hybrid-Technik werden beispielsweise integrierte Halbleiterschaltungen und diskrete (SMD-) Bauelemente auf einem gemeinsamen Träger aufgebracht. Damit das aufzulötende Bauelement selbst oder ein in der Umgebung der Löstelle befindlicher Halbleiterkristall durch die Hitze während des Lötvorgangs nicht beschädigt werden, sind geeignete Lötverfahren erforderlich.

Aus der EP-A 461 961 ist eine Anordnung zum Löten von Bauelementen auf einem Träger bekannt. Die Trägerplatinen werden mittels eines Förderapparates durch einen Heizofen befördert. In dem Heizofen sind paarweise ober- und unterhalb des Förderapparates mehrere Gebläse angeordnet. Diese Gebläse blasen heißes Gas durch eine poröse Platte auf die Trägerplatine. wodurch die Trägerplatine selbst und darauf aufgebrachte Lötpaste erhitzt wird. An die Erhitzungszone schließt sich eine Abkühlzone an, in der kaltes Gas gegen die Trägerplatine geblasen wird, wodurch das Lot erhärtet.

Da bei diesem Verfahren von oben und von unten heißes Gas gegen die Trägerplatine strömt und den gesamten im Gasstrom befindlichen Teil der Platine gleichmäßig erhitzt, können hitzeempfindliche Bauelemente, die sich bereits auf der Trägerplatine befinden, beschädigt werden. Ein weiteres Problem ist, daß bei einem Heißgasstrom von oben die Lötpaste während der Erhitzung von der Lötstelle wegfließen kann.

Aus der US-A-4 295 596 ist eine zweite Anordnung zum Löten von Bauelementen auf einen Träger bekannt, durch die heisses Gas mittels einer Düse an von der Oberseite der Trägerfolie auf eine Lötstelle gerichtet wird.

Der Erfindung liegt deshalb die Aufgabe zugrunde, ein verbessertes Lötverfahren und eine Anordnung zur Durchführung dieses Lötverfahrens anzugeben.

Diese Aufgabe wird bezüglich des Verfahrens dadurch gelöst, daß das heiße Gas mittels einer Düse als Heißgasstrahl auf eine Lötstelle gerichtet wird und diese so lange erwärmt, bis vom Heißgasstrahl erwärmtes Lot auf der Oberseite der Trägerfolie schmilzt. Dadurch, daß der Heißgasstrahl direkt auf eine Lötstelle gerichtet wird, wird nur das direkt an dieser Lötstelle befindliche Lot erhitzt und geschmolzen. Die Hitze dringt dabei durch die Trägerfolie hindurch, ohne die Folie selbst, das anzulötende Bauelement oder benachbarte Bauelemente zu schädigen. Der Heißgasstrahl wird abgeschaltet, sobald das Lot geschmolzen ist, worauf das Lot sehr schnell erstarrt. Durch diese An- und Abschaltung des Heißgasstrahls ist eine sehr genaue zeitliche Steuerung des Lötvorganges möglich, ohne daß eine Überhitzung auftritt.

In einer Ausgestaltung des Verfahrens ist erfindungsgemäß vorgesehen, daß das Gas zur Erhitzung durch einen beheizten Metallblock geleitet wird. Dies stellt eine verfahrenstechnisch sehr einfache Möglichkeit dar, das Gas auf eine gewünschte Temperatur zu erhitzen.

Bevorzugt sieht eine Weiterbildung des Verfahrens erfindungsgemäß vor, daß auf die Trägerfolie zuerst eine zähflüssige Lötpaste aufgebracht wird, daß ein Anschlußpunkt des anzulötenden Bauelements in die Lötpaste gebracht wird und daß danach der Lötvorgang erfolgt. Die Zähigkeit der Lötpaste bewirkt, daß das anzulötende Bauelement nicht verrutscht, während die Trägerfolie in die richtige Position über die Düse bewegt wird. Es ist somit nicht erforderlich, an der Unterseite der Anschlußpunkte des anzulötenden Bauelements ein Klebemittel zur Befestigung der Bauelemente an der Trägerfolie vor dem Lötvorgang anzubringen.

Besonders vorteilhaft ist eine Ausgestaltung des erfindungsgemäßen Verfahrens, bei der als Gas ein Inertgas, insbesondere Stickstoff, oder Druckluft verwendet wird. Zur Verwendung geeignet ist auch ein unter der Handelsbezeichnung "Menggas" bekanntes Gasgemisch aus Stickstoff mit etwa 2 - 3% Wasserstoffzusatz. Dadurch sollen Oxydationen an den Lötstellen und in einem beheizten Metallblock beim Durchströmen des Gases verhindert werden. Durch Oxydation in den Gasstrom gelangende Partikel würden beispielsweise eine auf der Trägerfolie befindliche Halbleiterkristallschaltung, die noch nicht durch Abdeckmaterial geschützt ist, verschmutzen und zu Störungen führen. Der Heißgasstrahl sollte deshalb möglichst partikelfrei sein.

Eine Anordnung zur Durchführung des erfindungsgemäßen Verfahrens ist dadurch gekennzeichnet, daß unterhalb der Trägerfolie eine auf die Lötstelle gerichtete Düse angeordnet ist, durch die ein an- und abschaltbarer Heißgasstrahl auf die Lötstelle geleitet wird.

In einer Ausgestaltung dieser Anordnung ist erfindungsgemäß vorgesehen, daß die Düse an einem beheizten Metallblock angebracht ist, durch den das Gas zur Erhitzung strömt. Damit während der Erhitzung des Gases in dem Metallblock keine Oxydationen auftreten und dadurch Partikel in den Gasstrom gelangen, besteht der Metallblock bevorzugt aus zunderfreiem Stahl. Dies hat außerdem den Vorteil, daß der beheizte Metallblock sich nicht verzieht, d.h., daß der Metallblock sich während des Aufheizens und Abkühlens oder während des Betriebes aufgrund der Wärmeausdehnung nur sehr geringfügig verformt. Dadurch ist gewährleistet, daß die Strömungsrichtung des Heißgasstrahls durch die Düse sich nicht verändert. da sich auch die Position der Düse nicht ändert.

In einer Weiterbildung ist erfindungsgemäß vorgesehen, daß der Metallblock im Innern eine mäanderförmige Bohrung aufweist, durch die das Gas bis zur Düse geleitet wird. Damit das Gas auf dem Weg durch den Metallblock möglichst stark erhitzt wird, ist die Bohrung auf diese Weise möglichst lang ausgeführt.

Um "kalte" Lötstellen zu vermeiden, ist vorteilhafterweise in einer Weiterbildung vorgesehen, daß während des Lötvorgangs das Bauelement durch eine Haltevorrichtung in Position gehalten wird, bis das Lot erhärtet ist.

Weitere erfindungsgemäße Ausgestaltungen ergeben sich aus den Unteransprüchen.

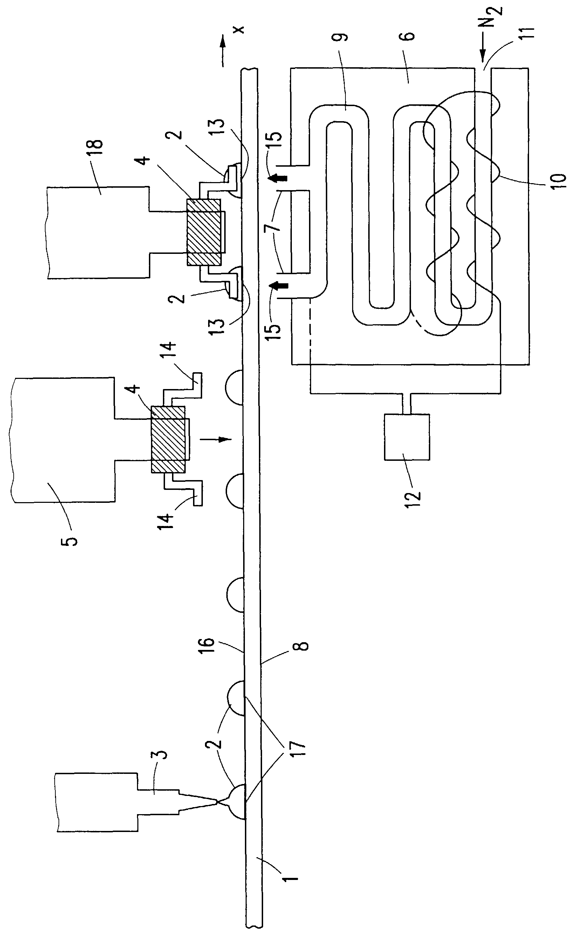

Die Erfindung wird nachfolgend anhand der einzigen Figur näher erläutert. Dargestellt ist eine Anordnung zur Durchführung des erfindungsgemäßen Lötverfahrens, bei der die einzelnen Verfahrensschritte erkennbar sind.

Mit 1 ist eine dünne, flexible Trägerfolie bezeichnet, auf deren Oberseite 16 verschiedene Bauelemente, beispielsweise eine Spule 4 angelötet werden sollen. Nicht dargestellt in der Figur sind Verbindungsleitungen und andere Bauelemente wie beispielsweise eine hochintegrierte Schaltung auf einem Siliziumkristall, die sich vor Durchführung des erfindungsgemäßen Verfahrens bereits auf der Oberseite 16 der Trägerfolie 1 befinden können.

Wie im linken Teil der Figur dargestellt ist, wird zunächst auf die Oberseite 16 der Trägerfolie 1 aus einer Lötmittelspritze 3 das Lot an den Kontaktstellen 17 aufgebracht, an denen die Spule 4 auf die Trägerfolie 1 gelötet werden soll. Als Lot wird bevorzugt eine aufgrund ihrer Viskosität zähflüssige Lötpaste verwendet, die an den Kontaktstellen 17 jeweils einen halbkugelförmigen Lötmitteltropfen 2 bildet.

Im nächsten Verfahrensschritt (mittlerer Teil der Figur) wird die Spule 4 von einer Positioniervorrichtung 5 mit ihren Anschlußpunkten 14 in die Lötmitteltropfen 2 eingebracht. Aufgrund der Zähflüssigkeit der Lötpaste umschließt diese die Anschlußpunkte 14 der Spule 4, wie im rechten Teil der Figur gezeigt ist. Danach erfolgt der eigentliche Lötvorgang.

Unterhalb der Trägerfolie 1 befindet sich ein aus zunderfreiem Stahl bestehender Metallblock 6, der im Innern eine mäanderförmig verlaufende Bohrung 9 aufweist. Diese Bohrung 9 endet zur Unterseite 8 der Trägerfolie 1 hin in zwei, aus dem Metallblock 6 herausragende Düsen 7. Diese Düsen 7 sind so beabstandet, daß sie den Lötstellen 13 direkt gegenüberliegen.

Die Erhitzung des Metallblocks 6 erfolgt durch im Innern des Metallblocks 6 die Bohrung 9 wendelförmig umschließende Heizwendel 10. Diese Heizwendel 10 werden von einer nur symbolisch dargestellten elektrischen Heizung 12 gespeist. Diese Heizwendel 10 sind in der Figur nur im unteren Bereich des Metallblocks 6 dargestellt, sind aber als in gleicher Weise im restlichen Teil des Metallblocks 6 fortgesetzt zu betrachten.

Um den Lötvorgang in Gang zu setzen, wird von der Eingangsöffnung 11 der Bohrung 9 her Stickstoff (N₂) in die Bohrung 9 mit einstellbarem Durchfluß eingeleitet. Während das Gas durch die Bohrung 9 bis zu den Düsen 7 strömt, wird es aufgrund der hohen Temperatur des Metallblocks 6 erhitzt. Aus den Düsen 7 strömt der Heißgasstrahl 15 aus und ist direkt auf die Lötstellen 13 gerichtet. Dadurch schmilzt das Lot an den Lötstellen 13. Aufgrund der Richtungswirkung der Düsen 7 werden nur die Lötmitteltropfen 2. nicht aber die Spule 4 oder andere in der Umgebung der Lötstellen 13 befindliche Bauelemente oder Leitungen erhitzt.

Sobald die Stickstoffzufuhr und damit der Heißgasstrahl 15 abgeschaltet wird, erstarrt das Lot 2 sehr schnell. Sobald das Lot 2 vollständig erstarrt ist, ist die Spule 4 mechanisch fest und elektrisch leitend mit beispielsweise einer Leiterbahn auf der Oberseite 16 der Trägerfolie 1 verbunden.

Während dieses Lötvorgangs wird das anzulötende Bauelement 4 insbesondere während des Erstarrungsprozesses des Lotes 2 bewegungsunfähig von einer weiteren Haltevorrichtung 18 in Position gehalten. Dadurch wird verhindert, daß sich eine "kalte" Lötstelle bildet.

Damit das Gas von der Eintrittsöffnung 11 bis zu den Düsen 7 möglichst stark erhitzt wird, ist die Bohrung 9 durch den Metallblock 6 möglichst lang ausgeführt. Dies wird dadurch erreicht, daß die Bohrung 9 in mäanderförmigen Windungen durch den gesamten Metallblock 6 geführt ist. In einem praktischen Beispiel hat der Heißgasstrom 15 an den Düsen eine Temperatur von 280°C bei einer Temperatur des Metallblocks von 400°C.

Der Metallblock 6 kann auch mehr als eine Bohrung 9 und auch mehr als nur eine oder zwei Düsen 7 am Ende jeder Bohrung aufweisen. Dadurch ist es möglich, mehrere Bauelemente gleichzeitig auf einer oder verschiedenen Trägerfolien 1 aufzulöten. Die Düsen 7 sind so angeordnet. daß die Heißgasstrahlen 15 direkt auf die Lötstellen 13 gerichtet sind.

In einem praktischen Aufbau werden die drei gezeigten Verfahrensschritte (Aufbringen der Lötpaste. Aufsetzen des Bauelements, eigentlicher Lötvorgang) durch hintereinander angeordnete Vorrichtungen ausgeführt. Die Trägerfolie wird dabei mittels einer Positioniereinheit schrittweise an den einzelnen Vorrichtungen vorbei in der mit dem Pfeil x angedeuteten Richtung bewegt. Aufgrund der Zähflüssigkeit der Lötpaste bleibt das Bauelement 4, nachdem es von der Positioniervorrichtung 5 auf die Trägerfolie 1 aufgesetzt ist. beim Verschieben in die nächste Position ohne Verrutschen auf der Trägerfolie 1 sitzen. Ein häufig dazu an der Unterseite der Anschlußpunkte 14 verwendeter Kleber entfällt deshalb.

Angewendet wird das erfindungsgemäße Verfahren beispielsweise bei der Herstellung einer Transponder-Schaltung, bei der Signale berührungslos an einen Empfänger übertragen werden. Diese Schaltung umfaßt auf der Trägerfolie neben Halbleiterschaltungen auch eine als diskretes Bauelement ausgestaltete Spule. Die Spule dabei wird als letztes Bauelement auf die Trägerfolie mit dem erfindungsgemäßen Verfahren gelötet und danach wird die gesamte Schaltung vergossen.

Das erfindungsgemäße Verfahren bietet eine einfache, kostengünstige und schnelle Möglichkeit, diskrete Bauelemente auf flexiblen Trägerfolien aufzulöten. Eine Beschädigung der anzulötenden oder benachbarter Bauelemente wird dabei dadurch verhindert, daß die Hitze zum Schmelzen des Lotes nur punktuell auf die Lötstelle gerichtet wird. Außerdem kann dieses Verfahren maschinell und berührungslos durchgeführt werden. Automatisches Anlöten von Bauelementen auf einer flexiblen Trägerfolie in großer Stückzahl ist dadurch möglich.

## Patentansprüche

1. Verfahren zum Löten von Bauelementen (1) auf einer Trägerfolie (1), bei dem heißes Gas auf die Unterseite (8) der Trägerfolie (1) geleitet wird, und bei dem das heiße Gas mittels einer Düse als Heißgasstrahl (15) auf eine Lötstelle (13) gerichtet wird und diese so lange erwärmt, bis vom Heißgasstrahl (15) erwärmtes Lot (2) auf der Oberseite (16) der Trägerfolie (1) schmilzt.

2. Verfahren nach Anspruch 1,
dadurch gekennzeichnet, daß das Gas zur Erhitzung durch einen beheizten Metallblock (6) geleitet wird.

3. Verfahren nach einem der Ansprüche 1 oder 2,
dadurch gekennzeichnet, daß auf die Trägerfolie (1) zuerst eine zähflüssige Lötpaste (2) aufgebracht wird, daß ein Anschlußpunkt (14) des anzulötenden Bauelements (4) in die Lötpaste (2) gebracht wird und daß danach der Lötvorgang erfolgt.

4. Verfahren nach einem der Ansprüche 1 bis 3,
dadurch gekennzeichnet, daß als Gas ein Inertgas, insbesondere Stickstoff, oder Druckluft verwendet wird.

5. Anordnung zur Durchführung des Verfahrens nach Anspruch 1,
bei dem unterhalb der Trägerfolie (1) eine auf die Lötstelle (13) gerichtete Düse (7) angeordnet ist, durch die ein an- und abschaltbarer Heißgasstrahl (15) auf die Lötstelle (13) geleitet wird.

6. Anordnung nach Anspruch 5,
dadurch gekennzeichnet, daß die Düse (7) an einem beheizten Metallblock (6) angebracht ist, durch den das Gas zur Erhitzung strömt.

7. Anordnung nach Anspruch 6,
dadurch gekennzeichnet, daß der Metallblock (6) aus zunderfreiem Stahl besteht.

8. Anordnung nach einem der Ansprüche 6 bis 7,
dadurch gekennzeichnet, daß der Metallblock (6) im Innern eine mäanderförmige Bohrung (9) aufweist, durch die das Gas bis zur Düse (7) geleitet wird.

9. Anordnung nach einem der Ansprüche 6 bis 8,
dadurch gekennzeichnet, daß der Metallblock (6) im Innern Heizwendel (10) zur Erhitzung des Metallblocks (6) aufweist.

10. Anordnung nach einem der Ansprüche 5 bis 9,
dadurch gekennzeichnet, daß während des Lötvorgangs das Bauelement (4) durch eine Haltevorrichtung (18) in Position gehalten wird, bis das Lot (2) erhärtet ist.

## Claims

1. A method of soldering components (4) on a carrier foil (1), by which method hot gas is conducted onto the lower side (8) of the carrier foil (1), in which method the hot gas is aimed as a hot gas jet (15) at a soldering spot (13) by means of a nozzle and heats said spot until solder (2) present on the upper side (16) of the carrier foil (1) and heated by the hot gas jet (15) melts.

2. A method as claimed in Claim 1,
characterized in that the gas is heated in that it is passed through a heated metal block (6).

3. A method as claimed in Claim 1 or 2,
characterized in that a viscous soldering paste (2) is first provided on the carrier foil (1), a connection point (14) of the component (4) to be soldered is introduced into the soldering paste (2), and the soldering process takes place subsequently.

4. A method as claimed in one of the Claims 1 to 3,
characterized in that an inert gas, in particular nitrogen, or compressed air is used as the gas.

5. A device for carrying out the method as claimed in Claim 1,
wherein a nozzle (7) is arranged below the carrier foil (1) and aimed at the soldering spot (13), through which nozzle the switchable hot gas flow (15) is conducted towards the soldering spot (13).

6. A device as claimed in Claim 5,
characterized in that the nozzle (7) is provided at a heated metal block (6) through which the gas is passed so as to be heated.

7. A device as claimed in Claim 6,
characterized in that the metal block (6) is made from scale-free steel.

8. A device as claimed in Claim 6 or 7,
characterized in that the metal block (6) comprises a meandering passage (9) in its interior through which the gas is guided to the nozzle (7).

9. A device as claimed in one of the Claims 6 to 8,
characterized in that the metal block (6) comprises heater coils (10) for heating the metal block (6) in its interior.

10. A device as claimed in one of the Claims 5 to 9,
characterized in that the component (4) is held in position by a retaining device (18) during the soldering process until the solder (2) has solidified.

## Revendications

1. Procédé de soudage de composants (1) sur une feuille de support (1), du gaz chaud étant dirigé sur la face inférieure 8 de la feuille de support (1) et le gaz chaud étant dirigé à l'aide d'un gicleur sous la forme d'un flux de gaz chaud (15) sur un joint de soudage (13) et chauffé jusqu'à ce que le métal d'apport (2) chauffé par le flux de gaz chaud (15) fonde sur la face supérieure (16) de la feuille de support (1).

2. Procédé selon la revendication 1, caractérisé en ce que le gaz est dirigé en vue de son chauffage au travers d'un bloc métallique (6) chauffé.

3. Procédé selon l'une des revendications 1 ou 2, caractérisé en ce qu'une pâte décapante visqueuse (2) est d'abord appliquée sur la feuille de support (1), qu'un terminal (14) du composant à souder (4) est introduit dans la pâte décapante (2) et que la procédure de soudage se déroule ensuite.

4. Procédé selon l'une des revendications 1 à 3, caractérisé en ce qu'un gaz inerte, en particulier l'azote ou l'air comprimé est utilisé comme gaz.

5. Dispositif de mise en oeuvre du procédé selon la revendication 1, un gicleur (7) dirigé sur le joint de soudage (13) étant disposé sous la feuille de support (1), par lequel un flux de gaz chaud susceptible d'être amené et interrompu (15) est dirigé sur le joint soudé (13).

6. Dispositif selon la revendication 5, caractérisé en ce que le gicleur (7) est appliqué contre un bloc métallique (6) chauffé par lequel le gaz circule en vue de son chauffage.

7. Dispositif selon la revendication 6, caractérisé en ce que le bloc métallique (7) se compose d'acier exempt de pailles.

8. Dispositif selon l'une des revendications 6 à 7, caractérisé en ce que le bloc métallique (6) présente à l'intérieur un alésage (9) en méandres par lequel le gaz est amené jusqu'au gicleur (7).

9. Dispositif selon l'une des revendications 6 à 8, caractérisé en ce que le bloc métallique (6) présente à l'intérieur des filaments chauffants (10) en vue du chauffage du bloc métallique (6).

10. Dispositif selon l'une des revendications 5 à 9, caractérisé en ce que le composant (4) est maintenu en position par un dispositif de retenue (18) pendant la procédure de soudage jusqu'à ce que le métal d'apport (2) soit durci.
